(19) Europäisches Patentamt / European Patent Office / Office européen des brevets

(11) **EP 2 281 207 B1**

(12) **EUROPÄISCHE PATENTSCHRIFT**

(45) Veröffentlichungstag und Bekanntmachung des Hinweises auf die Patenterteilung:
**02.11.2011 Patentblatt 2011/44**

(21) Anmeldenummer: **09753308.7**

(22) Anmeldetag: **20.05.2009**

(51) Int Cl.:
*G01R 31/14* *(2006.01)*     *G01R 31/12* *(2006.01)*

(86) Internationale Anmeldenummer:
**PCT/AT2009/000212**

(87) Internationale Veröffentlichungsnummer:
**WO 2009/143544 (03.12.2009 Gazette 2009/49)**

(54) **VLF-PRÜFGENERATOR**

VLF TEST GENERATOR

GÉNÉRATEUR DE TRÈS BASSE FRÉQUENCE POUR ESSAIS

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **28.05.2008 AT 8572008**

(43) Veröffentlichungstag der Anmeldung:
**09.02.2011 Patentblatt 2011/06**

(73) Patentinhaber: **Mohaupt High Voltage GmbH**
**6142 Mieders (AT)**

(72) Erfinder: **Mohaupt, Peter**
**6020 Innsbruck (AT)**

(74) Vertreter: **Weiser, Andreas**
**Patentanwalt**
**Kopfgasse 7**
**1130 Wien (AT)**

(56) Entgegenhaltungen:
**DE-B3- 10 333 241    GB-A- 1 008 461**

**Beschreibung**

Die vorliegende Erfindung betrifft einen VLF-Prüfgenerator zur Erzeugung einer Hochspannung mit Tieffrequenz für die Isolationsprüfung von kapazitiven Lasten, insbesondere Energiekabeln.

Für die energietechnische Isolationsprüfung von stark kapazitiven Lasten wie erdverlegten Kabelsystemen hat sich die Prüfung mit Hochspannungen sehr tiefer Frequenz ("very low frequency", VLF) im Bereich von Zehntel Hertz etabliert. Im Gegensatz zu netzfrequenten oder höherfrequenten Prüfspannungen rufen VLF-Prüfspannungen nur geringe Blindleistung in der kapazitiven Last hervor, so daß der Prüfgenerator entsprechend kleiner ausgelegt werden kann; und im Vergleich zu früher verwendeten Gleichspannungsprüfungen verhindern VLF-Prüfspannungen den Aufbau schädlicher Raum- und Restladungen im Kabelsystem, die später im Betrieb zu Durchschlägen führen können.

Die Erzeugung geeigneter VLF-Prüfspannungen im Hochspannungsbereich, d.h. mit bis zu einigen hundert Kilovolt, ist jedoch keineswegs einfach, da Hochspannungstransformatoren für derart tiefe Frequenzen nicht praktikabel sind. Es wurden daher bereits verschiedenste Schaltungen für VLF-Prüfgeneratoren vorgeschlagen, die jedoch alle entweder hohen Schaltungsaufwand oder kostspielige bzw. störungsanfällige Bauteile haben.

So ist beispielsweise aus der DE 103 33 241 B ein VLF-Prüfgenerator der eingangs genannten Art bekannt, welcher einen Stelltransformator mit motorgetriebener Verstellung verwendet, um eine netzfrequente Hochspannung durch periodische Verstellung des Transformators in der Amplitude zu modulieren. Die amplitudenmodulierte Hochspannung wird aufwärts transformiert, und anschließend wird mit Hilfe eines Demodulators die Modulationsfrequenz als VLF-Hochspannung wiedergewonnen. Die Verwendung eines elektromotorisch betätigten Stelltransformators macht diese Lösung unhandlich, störungsanfällig und nur für geringe Prüfleistungen einsetzbar.

Andere bekannte Konstruktionen verwenden aufwendige Hochspannungs-Halbleiterschaltungen, um eine netzfrequente Hochspannung zunächst gleichzurichten und dann mit Hilfe gesteuerter Halbleiterschalter periodisch abzuregeln, gleichsam in der Art eines Hochspannungs-Wechselrichters, um eine VLF-Hochspannung zu erzeugen. Diese Konstruktionen kommen zwar ohne mechanische Bauteile aus, erfordern jedoch umfangreiche Leistungselektronik, welche auch einen hohen Kühlbedarf hat.

Die Erfindung setzt sich zum Ziel, die Nachteile des bekannten Standes der Technik zu überwinden und einen VLF-Prüfgenerator für die Erzeugung tieffrequenter Hochspannungen zu schaffen, welcher einfach und kostengünstig realisiert werden kann, geringes Gewicht für einen transportablen Einsatz vor Ort hat, robust und störungsunanfällig ist und nur geringe Kühlleistung erfordert.

Dieses Ziel wird mit einem VLF-Prüfgenerator der einleitend genannten Art erreicht, der sich gemäß der Erfindung auszeichnet durch

zwei Oszillatoren, deren Oszillatorfrequenzen sich um das Doppelte der genannten Tieffrequenz voneinander unterscheiden,

einen von den Oszillatoren interferierend gespeisten, auf die Oszillatorfrequenzen abgestimmten Resonanzkreis zur Spannungsüberhöhung der interferierenden Oszillatorfrequenzen, und

einen Demodulator zum Auskoppeln der durch die Interferenz erzeugten tieffrequenten Hochspannung aus dem Resonanzkreis und Anlegen an die Last.

In Abkehr von allen bekannten Lösungen beruht die Erfindung auf dem neuen Ansatz, die Interferenz bzw. Schwebung zwischen zwei geringfügig differierenden Oszillatoren zur Erzeugung einer tieffrequenten Modulation in einem Resonanzkreis heranzuziehen, welcher gleichzeitig eine Spannungsüberhöhung des Interferenzproduktes bewirkt. Auf diese Weise kann mit überraschend wenigen Bauteilen eine Ausgangsspannung sehr hoher Amplitude und sehr tiefer Frequenz erzeugt werden. Störungsanfällige mechanische Elemente oder aufwendige Leistungselektroniken mit hohem Kühlbedarf entfallen zur Gänze. Aufgrund seines geringen Gewichts, Platzbedarfs und seiner Robustheit eignet sich der erfindungsgemäße VLF-Prüfgenerator besonders für den transportablen Einsatz bei Isolationsprüfungen vor Ort, z.B. von erdverlegten Energiekabeln.

In dem VLF-Prüfgenerator der Erfindung können Oszillatoren mit weit über der Netzfrequenz liegenden Oszillatorfrequenzen verwendet werden, da nur ihr Frequenzunterschied für die Erzeugung der VLF-Prüfspannung relevant ist. Bevorzugt liegen die Oszillatorfrequenzen im Bereich von 100 Hz bis 10 kHz, besonders bevorzugt im Bereich von 500 Hz bis 50 kHz, insbesondere bevorzugt bei etwa 1 kHz. Dadurch können volumen- und gewichtskritische Bauteile, wie die Drossel des Resonanzkreises oder optionale Anpassungstransformatoren, wesentlich kleiner dimensioniert werden.

Besonders vorteilhaft ist es, wenn die genannte Tieffrequenz unter 1 Hertz liegt, bevorzugt bei etwa 0,1 Hertz. Wie an sich bekannt, stellen sich bei derart tiefen Frequenzen nur äußerst geringe Blindleistungen im Lastkreis ein, sodaß der Prüfgenerator für entsprechend geringe Leistung dimensioniert werden kann.

In einer bevorzugten Ausführungsform der Erfindung beträgt die Güte des Resonanzkreises 10 bis 100, besonders bevorzugt 50 bis 80. Dies stellt einen ausgezeichneten Kompromiß zwischen maximaler Spannungsüberhöhung und guter Abstimmbarkeit des Resonanzkreises dar.

Die Interferenz der Oszillatorfrequenzen kann sowohl durch Interferenz der Oszillatorausgangsströme als auch -spannungen erfolgen. Bevorzugt ist die Interferenz eine Spannungsinterferenz. Dadurch kann der Resonanzkreis bereits mit doppelter Spannungsamplitude angeregt und nach der Spannungsüberhöhung im Resonanzkreis die doppelte Generatorausgangsspannung erreicht werden.

Die Spannungsüberhöhung im Resonanzkreis eröffnet insbesondere auch die Möglichkeit, für die Oszillatoren herkömmliche steuerbare Halbleiter-Wechselrichter einzusetzen, wie sie in Form sog. "Power-Module" bekannt sind und z.B. aus einer netzfrequenten Versorgungsspannung von 400 V beliebige Ausgangsspannungsverläufe von bis zu 400 V erzeugen können; alleine durch die Spannungsüberhöhung im Resonanzkreis können daraus Ausgangsspannungen im Bereich von einigen zehn kV gewonnen werden.

Besonders günstig ist es, wenn gemäß einem weiteren Merkmal der Erfindung die Oszillatoren den Resonanzkreis über zumindest einen Transformator speisen, wodurch eine galvanische Trennung der Oszillatoren vom Resonanz- und damit Hochspannungskreis erreicht und negative Rückwirkungen transienter Vorgänge der Hochspannungsseite auf die Oszillatoren verhindert werden können; darüber hinaus kann auf diese Weise eine induktive Last für die Oszillatorausgänge bereitgestellt werden, wie sie beispielsweise von den genannten Power Modulen gefordert wird.

Eine besonders vorteilhafte Ausführungsform der Erfindung zeichnet sich dadurch aus, daß die Transformatoren gleichzeitig dazu verwendet werden, die Oszillatorausgangsspannungen für die Einspeisung in den Resonanzkreis hochzutransformieren. Dadurch kann eine nochmalige Erhöhung der Ausgangsspannung des VLF-Prüfgenerators erreicht werden; durch die zweimalige Spannungserhöhung, einmal durch den Einspeisebzw. Erregertransformator für den Resonanzkreis und ein zweites Mal durch die Spannungsüberhöhung im Resonanzkreis selbst, können VLF-Prüfspannungen von bis zu einigen hundert kV, z.B. 400 kV, ausgehend von Oszillatorausgangspannungen im Bereich von einigen hundert Volt erzeugt werden. Im Falle der bevorzugten Spannungsinterferenz der Oszillatoren wird sogar eine dreimalige Spannungserhöhung erreicht; einmal durch die Spannungsinterferenz, einmal durch das Transformieren und einmal durch die Resonanzüberhöhung.

Falls gewünscht, können die Oszillatoren an eine gemeinsame Primärwicklung des Transformators angeschlossen werden, was den Bauteileaufwand verringert. Gemäß einer besonders bevorzugten Variante der Erfindung speist jeder Oszillator eine eigene Primärwicklung eines gemeinsamen Transformators, welcher an den Resonanzkreis angeschlossen ist. Dadurch kann eine gegenseitige galvanische Trennung der Oszillatoren erreicht werden.

Besonders vorteilhaft ist es, wenn die Oszillatorfrequenz des einen Oszillators von der Oszillatorfrequenz des anderen Oszillators abgeleitet ist, oder alternativ die Oszillatorfrequenzen der Oszillatoren von einem gemeinsamen Taktgeber abgeleitet sind. Aufgrund des erfindungsgemäßen Prinzips der VLF-Erzeugung mittels Schwebung kompensieren sich absolute Fehler der Oszillatorfrequenzen, so daß durch eine starre Koppelung der Oszillatoren eine wesentlich höhere Frequenzkonstanz der VLF-Schwingung erreicht werden kann als mit den bekannten Lösungen.

Die Demodulation der Tieffrequenz aus dem Interferenzprodukt im Resonanzkreis kann mit Hilfe jeder in der Technik bekannten Demodulatorschaltung bewerkstelligt werden. Eine schaltungstechnisch besonders einfache Lösung ergibt sich, wenn der Demodulator - wie an sich aus der genannten Schrift DE 103 33 241 B bekannt - die kapazitive Last mitverwendet und diese mittels eines Gleichrichters im Takt der Tieffrequenz umlädt.

Auch für den Gleichrichter kann jede in der Technik bekannte Gleichrichterschaltung verwendet werden. Besonders vorteilhaft ist es, wenn - wie an sich aus der DE 103 33 241 B bekannt - der Gleichrichter in seiner Durchlaßrichtung umschaltbar ist und bei jeder Halbwelle der Tieffrequenz umschaltet, wozu der Gleichrichter bevorzugt zwei antiparallele, mit Schaltern versehene Diodenzweige aufweist, welche Lösung minimalen Bauteilebedarf hat.

In einer weiteren bevorzugten Ausführungsform der Erfindung wird jeder Diodenzweig durch eine Kette von Dioden und zwischenliegenden Halbleiterschaltern gebildet, wodurch eine hohe Spannungsfestigkeit für hohe Ausgangsspannungen erreicht werden kann.

Gemäß noch einem weiteren bevorzugten Merkmal der Erfindung wird vorgesehen, daß die Schalter beim Umschalten kurzfristig überlappend gleichzeitig geschlossen sind. Dadurch kann der Einschwingvorgang der Generatorausgangsspannung beim Umschalten des Gleichrichters minimiert werden.

Ein besonders rasches Entladen der Last kann gefördert und damit ein unerwünschter Potentialsprung beim Nulldurchgang der Generatorausgangsspannung verhindert werden, wenn gemäß einer besonders bevorzugten Ausführungsform der Erfindung dem Demodulator ein zum Ausgang des Resonanzkreises zurückführender Entladewiderstand für die kapazitive Last parallelgeschaltet ist. Gegenüber herkömmlichen Schaltungen mit einem permanenten lastparallelen Entladewiderstand hat die erfindungsgemäße Schaltung wesentlich geringere Verlustleistung; und im Vergleich zu Lösungen mit einem schaltbaren lastparallelen Entladewiderstand erübrigt die erfindungsgemäße Lösung einen gesonderten Schalter: Denn der auf das Ausgangspotential des Resonanzkreises bezogene Entladewiderstand kommt immer dann besonders stark zur Wirkung, wenn das Inferenzprodukt im Resonanzkreis seinen Schwebungsknoten hat und damit dem Nullpotential nahekommt.

Besonders vorteilhaft ist es dabei, wenn gemäß einem weiteren Merkmal der Erfindung zusätzlich eine Steuereinrichtung für die Oszillatoren vorgesehen ist, welche die Amplitude ihrer Ausgangsspannungen am Ende jedes zweiten Viertels der Periode der Tieffrequenz reduziert, um die Entladung der Last über den Entladewiderstand zu unterstützen.

Wenn der Demodulator wie oben erörtert durch das Zusammenwirken eines Gleichrichters mit der kapazitiven Last gebildet ist, besteht eine weitere vorteilhafte Ausführungsform der Erfindung darin, den Entladewiderstand einfach dem Gleichrichter parallelzuschalten.

Eine weitere Vereinfachung ergibt sich, wenn in dem Fall, daß die Diodenzweige des Gleichrichters durch Ketten von Dioden und zwischenliegenden Halbleiterschaltern gebildet sind, jeder Diode und jedem Halbleiterschalter ein einzelner Widerstand parallelgeschaltet ist, welche alle gemeinsam den genannten Entladewiderstand bilden. Dadurch kann die Anzahl an erforderlichen Bauteilen noch weiter reduziert werden.

Die Erfindung wird nachstehend anhand eines in den beigeschlossenen Zeichnungen dargestellten Ausführungsbeispieles näher erläutert. In den Zeichnungen zeigt:

Fig. 1 ein Schalbild einer ersten Ausführungsform des VLF-Prüfgenerators der Erfindung;
Fig. 2 das im Resonanzkreis auftretende Interferenzprodukt, die Resonanzspannung $U_R$;
Fig. 3 die tieffrequente Modulation der Resonanzspannung $U_R$ nicht-maßstäblich vergrößert;
Fig. 4 ein Schaltbild einer zweiten Ausführungsform des VLF-Prüfgenerators der Erfindung;
Fig. 5 die Herabregelung der Oszillatorausgangsspannungen in jeder zweiten Viertelperiode der Tieffrequenz und die Schaltverläufe des Gleichrichters von Fig. 4 zur Unterstützung der Lastentladung;
die Fig. 6 und 7 zwei alternative Ausführungsformen für die Diodenzweige des Gleichrichters und den Entladewiderstand von Fig. 4; und
die Fig. 8 bis 10 alternative Schaltungsvarianten für den Anschluß der Oszillatoren an den Resonanzkreis.

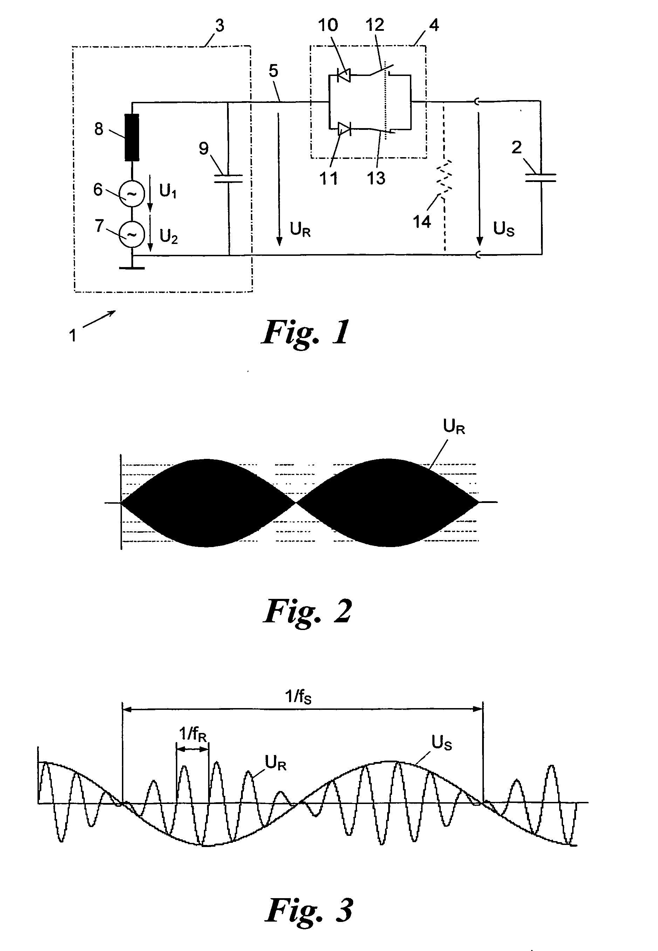

In Fig. 1 ist ein Prüfgenerator 1 dargestellt, der eine Hochspannung $U_S$ im Bereich von einigen 10 bis einigen 100 kV und mit einer sehr tiefen Frequenz ("very low frequency", VLF) im Bereich von einigen Hertz und darunter erzeugt. Der VLF-Prüfgenerator 1 dient zur Isolationsprüfung einer kapazitiven Last 2, beispielsweise eines unterirdischen Hochspannungskabels. Derartige Lasten 2 haben in der Regel eine Kapazität im Bereich von bis zu einigen μF. Die weitere Meßanordnung für die Isolationsprüfung der Last 2 nach Anlegen der tieffrequenten Hochspannung $U_S$, insbesondere für die Messung der Ausgangsspannung, für begleitende Diagnosemessungen wie Verlustfaktormessungen oder Teilentladungsmessungen usw., ist hier ohne Belang und nicht dargestellt.

Der Prüfgenerator 1 setzt sich im wesentlichen aus einem Oszillatorteil 3 und einem daran angeschlossenen Demodulator 4 zusammen. Der Oszillatorteil 3 erzeugt auf einem Ausgang 5 eine Hochspannung $U_R$ höherer Frequenz, welche mit der genannten Tieffrequenz amplitudenmoduliert ist, und der Demodulator 4 demoduliert das Modulationsprodukt $U_R$, um daraus eine tieffrequente Hochspannung $U_S$ als Generatorausgangsspannung zu gewinnen und an die Last 2 anzulegen.

Wie in Fig. 1 gezeigt, umfaßt der Oszillatorteil 3 zwei Oszillatoren 6, 7, deren Oszillatorfrequenzen $f_1$, $f_2$ sich um das Doppelte der gewünschten Tieffrequenz $f_S$ der Generatorausgangsspannung $U_S$ unterscheiden, d.h. $f_2 - f_1 = 2f_S$. Die Oszillatorfrequenzen $f_1$, $f_2$ sind bevorzugt wesentlich höher als die übliche Netzfrequenz elektrischer Energieverteilungsnetze (50 bzw. 60 Hz), und zwar in der Regel im Bereich von 100 Hz bis 10 kHz, bevorzugt im Bereich von 500 Hz bis 5 kHz, und besonders bevorzugt rund um 1 kHz, z.B. $f_1 = 1000,0$ Hz und $f_2 = 1000,2$ Hz.

Die Oszillatoren 6, 7 speisen gemeinsam in Serienschaltung einen durch eine Drossel 8 und einen Kondensator 9 gebildeten Resonanzkreis. Durch die gegenseitige Überlagerung bzw. Interferenz der Oszillatorausgangsspannungen $U_1$, $U_2$ stellt sich ein Interferenzprodukt im Resonanzkreis 8, 9 ein, das als Schwingung der Frequenz

$$f_R = \frac{f_1 + f_2}{2}$$

aufgefaßt werden kann, im weiteren als Resonanzspannung $U_R$ bezeichnet, welche mit einer tieffrequenten Schwebung $U_S$ der Frequenz

$$f_S = \frac{f_2 - f_1}{2}$$

amplitudenmoduliert ist, wie in der Fig. 2 und 3 gezeigt.

Da in dem genannten Beispiel $f_S = 0{,}1$ Hz beträgt, ist die 10.000-fach höherfrequente Resonanzspannung $U_R$ in Fig. 2 nur als Fläche ersichtlich; zur besseren Erkennbarkeit ist in Fig. 3 die Resonanzspannung $U_R$ mit nicht-maßstäblich vergrößerter Periode dargestellt.

Durch die Serienschaltung der Oszillatoren 6,7 beträgt die Amplitude der Erregerspannung $U_1 + U_2$ des Resonanzkreises 8, 9 das Doppelte der Amplituden der einzelnen Oszillatorausgangsspannungen $U_1$, $U_2$. Der Resonanzkreis 8, 9 ist auf die Frequenz $f_R$ der Erregerspannung $U_1 + U_2$ abgestimmt, so daß die Resonanzspannung $U_R$ am Resonanzkreis um die Güte Q des Resonanzkreises gegenüber den erregenden Oszillatorspannungen $U_1 + U_2$ spannungsüberhöht ist und damit das 2 Q-fache einer der Oszillatorausgangsspannungen $U_1$, $U_2$ erreicht.

Bevorzugt liegt die Güte Q des Resonanzkreises 8, 9 zwischen 10 und 100, besonders bevorzugt zwischen 50 und 80. Auf diese Weise kann durch die Spannungsinterferenz und die Spannungsüberhöhung im Resonanzfall des Resonanzkreises 8, 9 aus Oszillatorausgangsspannungen $U_1$, $U_2$ im Bereich von 3-400 V eine Resonanzspannung $U_R$ im Bereich von z.B. 60-80 kV erzeugt werden.

Zum Auskoppeln der tieffrequenten Hochspannung $U_S$ aus dem Resonanzkreis 8, 9 verwendet der hier dargestellte Demodulator 4 die Last 2 mit, u.zw. indem diese über einen geschalteten Gleichrichter 10 - 13 im Takt der Tieffrequenz $f_S$ umgeladen wird. Zu diesem Zweck umfaßt der Demodulator 4 zwei antiparallele Diodenzweige 10, 11, die mittels entsprechender Schalter 12, 13 bei jeder Halbwelle der Tieffrequenz $f_S$ wechselweise an den Ausgang 5 des Resonanzkreises 8, 9 angeschaltet werden.

Um einen allfälligen Spannungssprung im Nulldurchgang der Generatorausgangsspannung $U_S$ zu verhindern, welcher beispielsweise durch Spannungsabfälle im Gleichrichter 10 - 13 und/oder Restladungen in der Last 2 bedingt ist, kann optional ein Entladewiderstand 14 der Last 2 parallelgeschaltet werden. Der Entladewiderstand 14 kann permanent - oder mit Hilfe eines (nicht dargestellten) Schalters nur während der Phase des Nulldurchgangs der Ausgangsspannung $U_S$ - der Last 2 parallelgeschaltet werden.

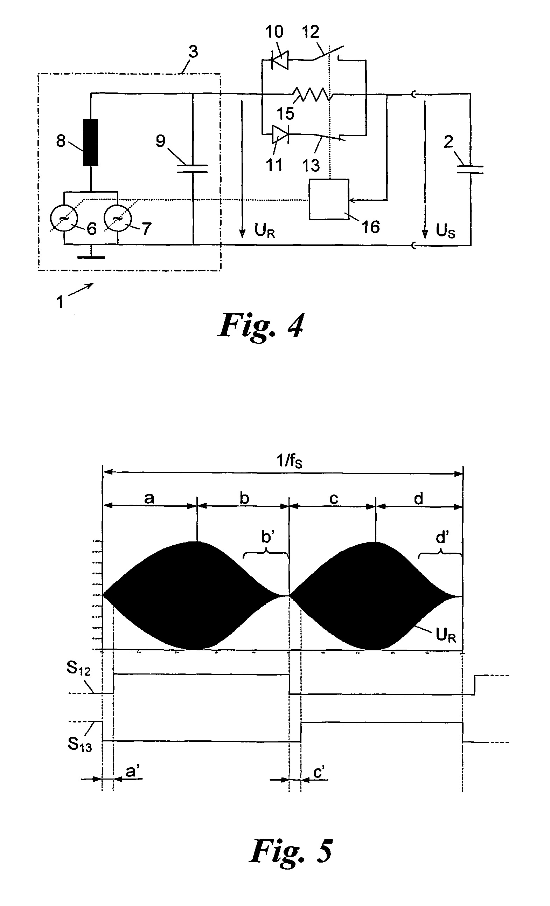

Anstelle eines solchen (schaltbaren) lastparallelen Entladewiderstandes 14, welcher hohe Verlustleistung und/oder zusätzliche Schaltelektronik bedingt, wird bevorzugt die folgende Entladeschaltung gemäß Fig. 4 eingesetzt.

Fig. 4 zeigt eine alternative Ausführungsform des VLF-Generators von Fig. 1, wobei gleiche Bezugszeichen gleiche Teile bezeichnen. Alternativ zu Fig. 1 sind bei dieser Ausführungsform die beiden Oszillatoren 6, 7 einander parallelgeschaltet und interferieren über ihre Ausgangsströme, es kann aber auch die Serienschaltung von Fig. 1 verwendet werden.

Bei der Ausführungsform von Fig. 4 liegt ferner dem Demodulator 4 (bzw. genauer seinen schaltbaren Diodenzweigen 10, 11) ein Entladewiderstand 15 parallel und entlädt die Last 2 zum Potential des Ausgangs 5 des Oszillatorteils 3 hin. Dadurch ist der Entladewiderstand 15 gerade in der Nulldurchgangsphase der Ausgangsspannung $U_S$ besonders wirksam, weil dort auch der Ausgang 5 aufgrund der Knotenpunkte der Resonanzfrequenz $U_R$ gegen Nullpotential geht.

Die Wirksamkeit des Entladewiderstandes 15 kann erhöht werden, indem gemäß Fig. 5 in den jeweils zweiten Vierteln b, d der vier Vierteln a - d der Periode der Tieffrequenz $f_S$ die Ausgangsspannungen $U_1$, $U_2$ der Oszillatoren 6, 7 geringfügig reduziert werden, und zwar insbesondere im Endteil b', d' der Viertel b, d, so daß die Hüllkurve der Resonanzspannung $U_R$ dort keinen exakt sinusförmigen Verlauf mehr hat. Der konkrete zeitliche Verlauf dieser Spannungsreduktion wird dabei mit Hilfe einer Steuerung 16, welche die Generatorausgangsspannung $U_S$ mißt, in einem Regelkreis so geregelt, daß sich unter Berücksichtigung der Spannungsabfälle in den Diodenzweigen 10, 11 und Schaltern 12, 13 und der Restladungen in der Last 2 insgesamt ein möglichst sinusförmiger Verlauf der Generatorausgangsspannung $U_S$ ergibt.

Der dem Demodulator 4 parallelgeschaltete Entladewiderstand 15 hat ein gewisses Übersprechen der Hochfrequenz $f_R$ auf die Ausgangsfrequenz $f_S$ zur Folge. Durch entsprechende Dimensionierung des Entladewiderstandes 15 und Steuerung der Spannungsreduzierung in den Bereichen b', d' kann dieser Effekt soweit minimiert werden, daß der Verzerrungsgrad bzw. Klirrfaktor der Generatorausgangsspannung $U_S$ z.B. unter 5% THD liegt.

Das Entladen der Last 2 beim Umschalten des Gleichrichters 10 - 13 kann noch durch eine weitere Maßnahme gefördert werden. In Fig. 5 sind die Schaltschemata $S_{12}$, $S_{13}$ der Schalter 12, 13 im zeitlichen Verlauf gezeigt. Wie ersichtlich, können sich die Ansteuerungen $S_{12}$, $S_{13}$ der Schalter 12, 13 während des Umschaltvorganges geringfügig überlappen, u.zw. so, daß die Schalter 12, 13 unmittelbar nach dem Nulldurchgang der Resonanzspannung $U_R$ kurzfristig beide gleichzeitig geschlossen sind (Bereiche a', c'). Dadurch kann der Einschwingvorgang der Generatorausgangsspannung $U_S$ beim Umschalten des Gleichrichters 10 - 13 minimiert und damit eine noch bessere Annäherung an einen ideal sinusförmigen Verlauf erreicht werden.

In dem gezeigten Beispiel einer VLF-Periodendauer $1/f_S$ von 10 s beträgt die Schließüberlappung a', c' bevorzugt ca. 0,1 s. Allgemein liegt die Schließüberlappung a', c' im Bereich von einigen Tausendstel bis einigen Hunderstel von $1/f_S$.

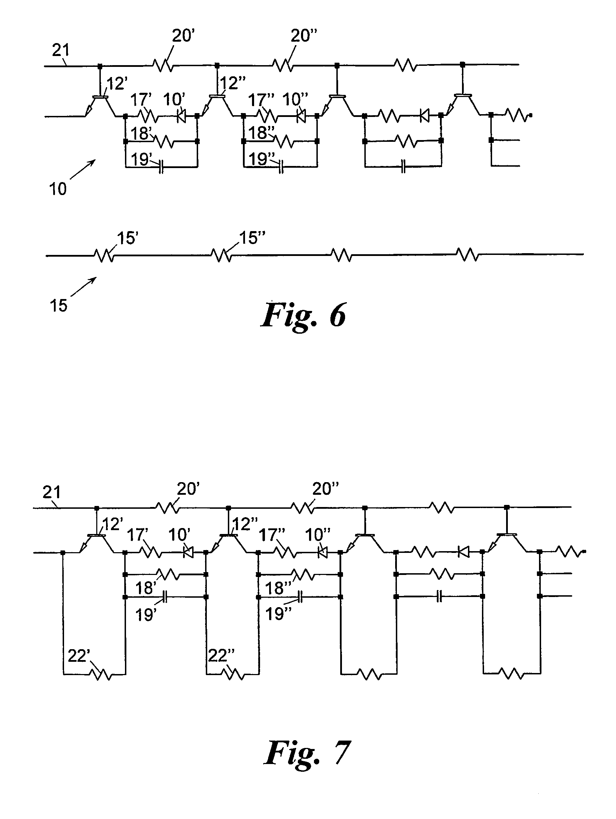

Fig. 6 zeigt eine erste praktische Ausführungsform für den Diodenzweig 10 und den Entladewiderstand 15 (Diodenzweig 11 ist spiegelbildlich). Wie in der Hochspannungstechnik bekannt, wird der Diodenzweig 10 bevorzugt durch eine Kette von einzelnen Dioden 10', 10" usw. und zwischenliegenden einzelnen Halbleiterschaltern 12', 12" usw. gebildet. Jede Diode 10', 10" ist mit einem seriellen Strombegrenzungswiderstand 17', 17" usw., einem parallelen Prüfwiderstand 18', 18" usw. und einem parallelen Schutzkondensator 19', 19" usw. beschaltet.

Die Ansteuerung der Halbleiterschalter 12', 12" ist durch eine mit Widerständen 20', 20" usw. versehene Steuerleitung 21, über welche das Schaltsignal $S_{12}$ zugeführt wird, schematisch versinnbildlicht; die konkrete Ansteuerschaltungen für die Halbleiterschalter 12', 12" ist dem Fachmann bekannt und hier nicht näher dargestellt. Der Entladewiderstand 15 ist zur Erhöhung der Spannungsfestigkeit aus seriengeschalteten Einzelwiderständen 15', 15" usw. zusammengesetzt.

Wie in Fig. 7 gezeigt, können optional die parallelen Prüfwiderstände 18', 18" der Dioden 10', 10" zur Bildung des Entladewiderstandes 15 mitverwendet werden. Zu diesem Zweck werden den Halbleiterschaltern 12', 12" Widerstände 22', 22" usw. parallelgeschaltet, welche gemeinsam mit den Prüfwiderständen 18', 18" - sowie der parallel dazu liegenden Widerstandskette des spiegelbildlichen Diodenzweiges 11 (nicht gezeigt) - den Entladewiderstand 15 bilden.

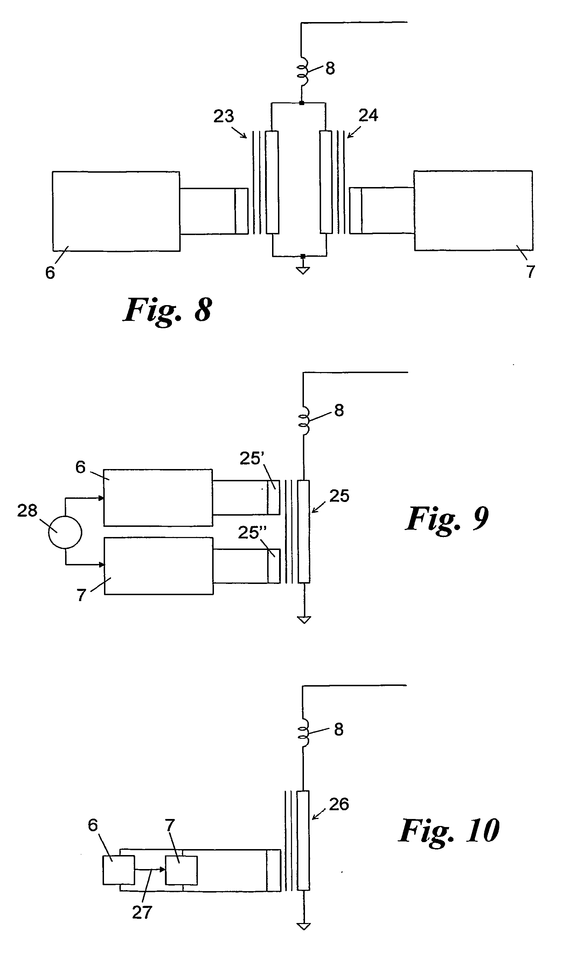

Die Fig. 8 bis 10 zeigen verschiedene praktische Ausführungen der Oszillatoren 6, 7 und deren Anbindung an den Resonanzkreis 8, 9 (nur teilweise dargestellt). Die Oszillatoren 6, 7 werden hier jeweils durch Halbleiter-Wechselrichter gebildet, deren Ausgangsspannungen mikroprozessorgesteuert sowohl in Frequenz als auch Amplitude beliebig regelbar sind (sog. "Power Module").

Bei der Ausführungsform von Fig. 8 speist jeder Oszillator 6, 7 den Resonanzkreis 8, 9 über einen eigenen Hochspannungstransformator 23, 24. Die Transformatoren 23, 24 dienen mehreren Zwecken: zur galvanischen Trennung der Oszillatoren 6, 7 vom Resonanzkreis 8, 9; zur galvanischen Trennung voneinander, zur Darbietung einer induktiven Last für die Oszillatoren 6, 7; und zum zusätzlichen Hochtransformieren der Oszillatorausgangsspannungen $U_1$, $U_2$ für die Anregung des Resonanzkreise 8, 9. Beispielsweise können damit Oszillatorausgangsspannungen $U_1$, $U_2$ von ca. 400 V auf eine Resonanzkreis-Erregerspannung von ca. 4 kV hochtransformiert werden, so daß mit einem Resonanzkreis der Güte Q = 100 eine Generatorausgangsspannung $U_S$ von ca. 400 kV erreicht werden kann.

Bei der Ausführungsform von Fig. 9 teilen sich die beiden Oszillatoren 6, 7 einen gemeinsamen Transformator 25, wobei jeder Oszillator eine eigene Primärwicklung 25', 25" des Transformators 25 speist, die auf dem Transformatorkern in Serie liegen, so daß sich hier wieder eine Spannungsinterferenz der Oszillatorausgangsspannungen $U_1$, $U_2$ ergibt.

Fig. 10 zeigt schließlich eine weitere Ausführungsform, bei welcher ein einziger Hochspannungstransformator 26 Verwendung findet, an dessen Primärwicklung die Oszillatoren 6, 7 in galvanischer Parallelschaltung (oder Serienschaltung, nicht gezeigt) angeschlossen sind, sodaß die Interferenz der Oszillatoren hier durch Strominterferenz (bzw. Spannungsinterferenz, nicht gezeigt) im Primärkreis erfolgt.

Wie durch den Pfeil 27 in Fig. 10 versinnbildlicht, kann die Oszillatorfrequenz $f_2$ des einen Oszillators 7 von der Oszillatorfrequenz $f_1$ des anderen Oszillators 6 abgeleitet sein, wodurch eine hohe Konstanz der Schwebungsfrequenz $f_S = (f_2 - f_1)/2$ erreicht werden kann. Alternativ können die Oszillatorfrequenzen $f_1$, $f_2$ der Oszillatoren 6, 7 auch von einem gemeinsamen Taktgeber 28 abgeleitet sein, siehe Fig. 9.

Wenn keine besonders hohe Ausgangsspannung $U_S$ erforderlich ist, können anstelle der spannungsübersetzenden Hochspannungstransformatoren 23 - 26 auch Anpaßtransformatoren zur Impedanzanpassung und galvanischen Trennung verwendet werden.

Die Erfindung ist nicht auf die dargestellten Ausführungsbeispiele beschränkt, sondern umfaßt alle Varianten und Modifikationen, insbesondere auch beliebige Kombinationen der gezeigten Ausführungsbeispiele, die in den Rahmen der angeschlossenen Ansprüche fallen.

## Patentansprüche

1. VLF-Prüfgenerator (1) zur Erzeugung einer Hochspannung ($U_S$) mit Tieffrequenz ($f_S$) für die Isolationsprüfung von kapazitiven Lasten (2), insbesondere Energiekabeln, **gekennzeichnet durch** zwei Oszillatoren (6, 7), deren Oszillatorfrequenzen ($f_1$, $f_2$) sich um das Doppelte der genannten Tieffrequenz ($f_S$) voneinander unterscheiden, einen von den Oszillatoren (6, 7) interferierend gespeisten, auf die Oszillatorfrequenzen ($f_1$, $f_2$) abgestimmten Resonanzkreis (8, 9) zur Spannungsüberhöhung ($U_R$) der interferierenden Oszillatorfrequenzen, und einen Demodulator zum Auskoppeln der **durch** die Interferenz erzeugten tieffrequenten Hochspannung ($U_S$) aus dem Resonanzkreis (8, 9) und Anlegen an die Last (2).

2. VLF-Prüfgenerator nach Anspruch 1, **dadurch gekennzeichnet, daß** die Oszillatorfrequenzen ($f_1$, $f_2$) im Bereich von 100 Hz bis 10 kHz liegen, bevorzugt im Bereich von 500 Hz bis 5 kHz, besonders bevorzugt bei etwa 1 kHz.

3. VLF-Prüfgenerator nach Anspruch 1 oder 2, **dadurch gekennzeichnet, daß** die Tieffrequenz ($f_S$) unter 1 Hertz liegt, bevorzugt bei etwa 0,1 Hertz.

4. VLF-Prüfgenerator nach einem der Ansprüche 1 bis 3, **dadurch gekennzeichnet, daß** die Güte (Q) des Resonanzkreises (8, 9) 10 bis 100 beträgt, bevorzugt 50 bis 80.

5. VLF-Prüfgenerator nach einem der Ansprüche 1 bis 4, **dadurch gekennzeichnet, daß** die Interferenz der Oszillatorfrequenzen ($f_1$, $f_2$) eine Spannungsinterferenz ($U_1 + U_2$) ist.

6. VLF-Prüfgenerator nach einem der Ansprüche 1 bis 5, **dadurch gekennzeichnet, daß** jeder Oszillator (6, 7) durch einen steuerbaren Halbleiter-Wechselrichter gebildet ist.

7. VLF-Prüfgenerator nach einem der Ansprüche 1 bis 6, **dadurch gekennzeichnet, daß** die Oszillatoren (6, 7) den Resonanzkreis über zumindest einen Transformator (23 - 26). speisen.

8. VLF-Prüfgenerator nach Anspruch 7, **dadurch gekennzeichnet, daß** der Transformator (23 - 26) die Oszillatorausgangsspannungen ($U_1$, $U_2$) hochtransformiert.

9. VLF-Prüfgenerator nach Anspruch 7 oder 8, **da-**

**durch gekennzeichnet, daß** jeder Oszillator (6, 7) eine eigene Primärwicklung (25', 25") eines gemeinsamen Transformators (25) speist, welcher an den Resonanzkreis (8, 9) angeschlossen ist.

10. VLF-Prüfgenerator nach einem der Ansprüche 1 bis 9, **dadurch gekennzeichnet, daß** die Oszillatorfrequenz ($f_2$) des einen Oszillators (7) von der Oszillatorfrequenz ($f_1$) des anderen Oszillators (6) abgeleitet ist.

11. VLF-Prüfgenerator nach einem der Ansprüche 1 bis 9, **dadurch gekennzeichnet, daß** die Oszillatorfrequenzen ($f_1$, $f_2$) der Oszillatoren (6, 7) von einem gemeinsamen Taktgeber (28) abgeleitet sind.

12. VLF-Prüfgenerator nach einem der Ansprüche 1 bis 11, **dadurch gekennzeichnet, daß** der Demodulator (4) die kapazitive Last (2) mitverwendet und diese mittels eines Gleichrichters (10 - 13) im Takt der Tieffrequenz ($f_2$) umlädt.

13. VLF-Prüfgenerator nach Anspruch 12, **dadurch gekennzeichnet, daß** der Gleichrichter (10 - 13) in seiner Durchlaßrichtung umschaltbar ist und bei jeder Halbwelle der Tieffrequenz ($f_2$) umschaltet.

14. VLF-Prüfgenerator nach Anspruch 13, **dadurch gekennzeichnet, daß** der Gleichrichter (10 - 13) zwei antiparallele, mit Schaltern (12, 13) versehene Diodenzweige (10, 11) aufweist.

15. VLF-Prüfgenerator nach Anspruch 14, **dadurch gekennzeichnet, daß** jeder Diodenzweig (10, 11) durch eine Kette von Dioden (10', 10") und zwischenliegenden Halbleiterschaltern (12', 12") gebildet ist.

16. VLF-Prüfgenerator nach Anspruch 14 oder 15, **dadurch gekennzeichnet, daß** die Schalter (12, 13) beim Umschalten kurzfristig überlappend (a', c') gleichzeitig geschlossen sind.

17. VLF-Prüfgenerator nach einem der Ansprüche 1 bis 16, **dadurch gekennzeichnet, daß** dem Demodulator (4) ein zum Ausgang (5) des Resonanzkreises (8, 9) zurückführender Entladewiderstand (15) für die kapazitive Last (2) parallelgeschaltet ist.

18. VLF-Prüfgenerator nach Anspruch 17, **dadurch gekennzeichnet, daß** eine Steuereinrichtung (16) für die Oszillatoren (6, 7) vorgesehen ist, welche die Amplitude ihrer Ausgangsspannungen ($U_1$, $U_2$) am Ende (b', d') jedes zweiten Viertels (b, d) der Periode der Tieffrequenz ($f_S$) reduziert, um die Entladung der Last (2) über den Entladewiderstand (15) zu unterstützen.

19. VLF-Prüfgenerator nach Anspruch 17 oder 18 in Verbindung mit einem der Ansprüche 12 bis 16, **dadurch gekennzeichnet, daß** der Entladewiderstand (15) dem Gleichrichter (10 - 13) parallelgeschaltet ist.

20. VLF-Prüfgenerator nach Anspruch 19 in Verbindung mit Anspruch 15, **dadurch gekennzeichnet, daß** jeder Diode (10', 10") und jedem Halbleiterschalter (12', 12") ein einzelner Widerstand (18', 18", 22', 22") parallelgeschaltet ist, welche gemeinsam den genannten Entladewiderstand (15) bilden.

**Claims**

1. VLF test generator (1) for generating a high voltage ($U_S$) with a low frequency ($f_S$) to test the insulation of capacitive loads (2), in particular power cables, **characterised by**
   two oscillators (6, 7), the oscillator frequencies ($f_1$, $f_2$) of which differ from one another by twine said low frequency ($f_s$),
   a resonant circuit (8, 9), which is fed in an interfering manner by the oscillators (6, 7) and is tuned to the oscillator frequencies ($f_1$, $f_2$), for voltage superelevation ($U_R$) of the interfering oscillator frequencies, and
   a demodulator for decoupling the low-frequency high voltage ($U_S$) generated by the interference from the resonant circuit (8, 9) and applying same to the load (2).

2. VLF test generator according to claim 1, **characterised in that** the oscillator frequencies ($f_1$, $f_2$) lie in the range of 100 Hz to 10 kHz, preferably in the range of 500 Hz to 5 kHz, particularly preferred at about 1 kHz.

3. VLF test generator according to claim 1 or 2, **characterised in that** the low frequency ($f_s$) lies below 1 hertz, preferably at about 0.1 hertz.

4. VLF test generator according to one of claims 1 to 3, **characterised in that** the quality (Q) of the resonant circuit (8, 9) amounts to 10 to 100, preferably 50 to 80.

5. VLF test generator according to one of claims 1 to 4, **characterised in that** the interference of the oscillator frequencies ($f_1$, $f_2$) is a voltage interference ($U_1 + U_2$).

6. VLF test generator according to one of claims 1 to 5, **characterised in that** each oscillator (6, 7) is formed by a controllable semiconductor inverter.

7. VLF test generator according to one of claims 1 to 6, **characterised in that** the oscillators (6, 7) feed the resonant circuit via at least one transformer (23 - 26).

**8.** VLF test generator according to claim 7, **characterised in that** the transformer (23 - 26) steps up the oscillator voltages ($U_1$, $U_2$).

**9.** VLF test generator according to claim 7 or 8, **characterised in that** each oscillator (6, 7) feeds a separate primary winding (25', 25") of a common transformer (25), which is connected to the resonant circuit (8, 9).

**10.** VLF test generator according to one of claims 1 to 9, **characterised in that** the oscillator frequency ($f_2$) of one oscillator (7) is derived from the oscillator frequency ($f_1$) of the other oscillator (6).

**11.** VLF test generator according to one of claims 1 to 9, **characterised in that** the oscillator frequencies ($f_1$, $f_2$) of the oscillators (6, 7) are derived from a common clock generator (28).

**12.** VLF test generator according to one of claims 1 to 11, **characterised in that** the demodulator (4) also uses the capacitive load (2) and reloads this by means of a rectifier (10 - 13) in the cycle cf the low frequency ($f_2$).

**13.** VLF test generator according to claim 12, **characterised in that** the rectifier (10 - 13) can be switched over in its transmitting direction and switches over upon each half wave of the low frequency ($f_2$).

**14.** VLF test generator according to claim 13, **characterised in that** the rectifier (10 - 13) has two antiparallel diode branches (10, 11) provided with switches (12, 13).

**15.** VLF test generator according to claim 14, **characterised in that** each diode branch (10, 11) is formed by a chain of diodes (10', 10") and interposed semiconductor switches (12', 12").

**16.** VLF test generator according to claim 14 or 15, **characterised in that** the switches (12, 13) are, during switchover, simultaneously closed with a brief overlap (a', c').

**17.** VLF test generator according to one of claims 1 to 16, **characterised in that** a discharging resistor (15) for the capacitive load (2), which connects back to the output (5) of the resonant circuit (8, 9), is connected in parallel to the demodulator (4).

**18.** VLF test generator according to claim 17, **characterised in that** a control means (16) is provided for the oscillators (6, 7), which reduces the amplitude of their output voltages ($U_1$, $U_2$) at the end (b', d') of each second quarter (b, d) of the period of the low frequency ($f_s$) in order to support the discharge of the load (2) via the discharging resistor (15).

**19.** VLF test generator according to claim 17 or 18 in association with one of claims 12 to 16, **characterised in that** the discharging resistor (15) is connected in parallel to the rectifier (10 - 13).

**20.** VLF test generator according to claim 19 in association with claim 15, **characterised in that** a single resistor (18', 18", 22', 22") is connected in parallel to each diode (10', 10") and each semiconductor switch (12', 12"), which single resistors jointly form said discharging resistor (15).

**Revendications**

**1.** Générateur TBF pour essais (1), destiné à produire une haute tension ($U_s$) à une très basse fréquence ($f_s$) pour tester l'isolation de charges capacitives (2), en particulier de câbles d'énergie, **caractérisé par** deux oscillateurs (6, 7) dont les fréquences d'oscillation ($f_1$, $f_2$) diffèrent d'une valeur égale au double de ladite très basse fréquence ($f_s$), un circuit résonant (8, 9) adapté aux fréquences d'oscillation ($f_1$, $f_2$) et alimenté en mode interférentiel par les oscillateurs (6, 7) pour produire une élévation de tension ($U_R$) des fréquences d'oscillation interférentielles, et un démodulateur destiné à découpler la haute tension ($U_s$) à très basse fréquence générée par l'interférence du circuit résonant (8, 9) et l'appliquer à la charge (2).

**2.** Générateur TBF pour essais selon la revendication 1, **caractérisé en ce que** les fréquences d'oscillation ($f_1$, $f_2$) se situent dans une plage allant de 100 Hz à 10 kHz, de préférence dans une plage allant de 500 Hz à 5 kHz, et de manière particulièrement préférée elles sont voisines de 1 kHz.

**3.** Générateur TBF pour essais selon la revendication 1 ou 2, **caractérisé en ce que** la très basse fréquence ($f_s$) est inférieure à 1 hertz, de préférence voisine de 0,1 hertz.

**4.** Générateur TBF pour essais selon l'une des revendications 1 à 3, **caractérisé en ce que** le factcur de qualité (Q) du circuit résonant (8, 9) se situe dans une plage allant de 10 à 100, de préférence de 50 à 80.

**5.** Générateur TBF pour essais selon l'une des revendications 1 à 4, **caractérisé en ce que** l'interférence des fréquences d'oscillation ($f_1$, $f_2$) est une interférence de tension ($U_1$ + $U_2$).

**6.** Générateur TBF pour essais selon l'une des revendications 1 à 5, **caractérisé en ce que** chaque oscillateur (6, 7) est formé par un circuit onduleur à semi-conducteurs commandables.

**7.** Générateur TBF pour essais selon l'une des revendications 1 à 6, **caractérisé en ce que** les oscillateurs (6, 7) alimentent le circuit résonant par le biais d'au moins un transformateur (23 - 26).

**8.** Générateur TBF pour essais selon la revendication 7, **caractérisé en ce que** le transformateur (23 - 26) élève les tensions de sortie des oscillateurs ($U_1$, $U_2$).

**9.** Générateur TBF pour essais selon la revendication 7 ou 8, **caractérisé en ce que** chaque oscillateur (6, 7) alimente un enroulement primaire spécifique (25', 25") d'un transformateur commun (25) qui est connecté au circuit résonant (8, 9).

**10.** Générateur TBF pour essais selon l'une des revendications 1 à 9, **caractérisé en ce que** la fréquence d'oscillation ($f_2$) d'un oscillateur (7) est dérivée de la fréquence d'oscillation ($f_1$) de l'autre oscillateur (6).

**11.** Générateur TBF pour essais selon l'une des revendications 1 à 9, **caractérisé en ce que** les fréquences d'oscillation ($f_1$, $f_2$) des oscillateurs (6, 7) sont dérivées d'une horloge commune (28).

**12.** Générateur TBF pour essais selon l'une des revendications 1 à 11, **caractérisé en ce que** le démodulateur (4) utilise conjointement la charge capacitive (2) et l'amène au moyen d'un redresseur (10 - 13) au rythme de la très basse fréquence ($f_2$).

**13.** Générateur TBF pour essais selon la revendication 12, **caractérisé en ce que** le redresseur (10 - 13) peut être commuté dans son sens passant et change de polarité à chaque demi-alternance de la très basse fréquence ($f_2$).

**14.** Générateur TBF pour essais selon la revendication 13, **caractérisé en ce que** le redresseur (10 - 13) présente deux circuits de diodes (10, 11) antiparallèles munis de commutateurs (12, 13).

**15.** Générateur TBF pour essais selon la revendication 14, **caractérisé en ce que** chaque circuit de diodes (10, 11) est formé par une chaîne de diodes (10', 10") et de commutateurs à semi-conducteurs intercalés (12', 12").

**16.** Générateur TBF pour essais selon la revendication 14 ou la revendication 15, **caractérisé en ce que** les commutateurs (12, 13) sont fermés en même temps en se chevauchant brièvement (a', c') lors de l'inversion de polarité.

**17.** Générateur TBF pour essais selon l'une des revendications 1 à 16, **caractérisé en ce qu'**une résistance de décharge (15) de la charge capacitive (2) rétrocouplée à la sortie (5) du circuit résonant (8, 9) est câblée en parallèle du démodulateur (4).

**18.** Générateur TBF pour essais selon la revendication 17, **caractérisé en ce qu'**il est prévu pour les oscillateurs (6, 7) un dispositif de commande (16) qui réduit l'amplitude de leurs tensions de sortie ($U_1$, $U_2$) à la fin (b', d') de chaque deuxième quart (b, d) de la période de la très basse fréquence ($f_s$) afin d'assister la décharge de la charge (2) par le biais de la résistance de décharge (15).

**19.** Générateur TBF pour essais selon la revendication 17 ou 18 en liaison avec l'une des revendications 12 à 16, **caractérisé en ce que** la résistance de décharge (15) est câblée en parallèle du redresseur (10 - 13).

**20.** Générateur TBF pour essais selon la revendication 19 en liaison avec la revendication 15, **caractérisé en ce que** des résistances individuelles (18', 18", 22', 22"), dont l'ensemble forme ladite résistance de décharge (15), sont câblées en parallèle de chaque diode (10', 10") et de chaque commutateur à semi-conducteur (12', 12").

**Fig. 1**

**Fig. 2**

**Fig. 3**

*Fig. 4*

*Fig. 5*

**Fig. 6**

**Fig. 7**

*Fig. 8*

*Fig. 9*

*Fig. 10*

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10333241 B